# EUROPÄISCHE PATENTSCHRIFT

(11) **EP 0 461 723 B1**
(45) Veröffentlichungstag und Bekanntmachung des Hinweises auf die Patenterteilung: **17.11.1994**
(21) Anmeldenummer: 91201434.7
(22) Anmeldetag: 11.06.1991
(51) Int. Cl.: G01R 33/34, G01R 33/36

(54) **Oberflächenspule für Kernresonanzuntersuchungen**
Surface coil for NMR examinations
Bobine de surface pour examens par RMN

(30) Priorität: 15.06.1990 DE 4019046
(43) Veröffentlichungstag der Anmeldung: 18.12.1991
(73) Patentinhaber: Philips Patentverwaltung GmbH, 22335 Hamburg (DE); Philips Electronics N.V., 5621 BA Eindhoven (NL)
(72) Erfinder: Wichern, Andreas, W-2100 Hamburg 90 (DE)
(74) Vertreter: Hartmann, Heinrich, Dipl.-Ing.

(56) Entgegenhaltungen:
- EP-A- 0 142 077
- EP-A- 0 412 749
- US-A- 4 783 641
- US-A- 4 906 933
- US-A- 4 928 064
- SOCIETY FOR MAGNETIC RESONANCE IMAGING, 8TH MEETING Bd. 2, August 1989, OAK BROOK, USA Seite 936; M. MEHDIZADEH: 'A Design Technique for Producing Desired Field Pattern in Generalized RF Coils'

## Beschreibung

Die Erfindung betrifft eine Oberflächenspule gemäß dem Oberbegriff des Anspruchs 1. Eine solche Oberflächenspule ist aus der US-A-4,783,641 bekannt. Dabei sind an den Längsleitern Anschlüsse für einen Hochfrequenzsender oder einen Hochfrequenzempfänger vorgesehen.

Die bekannte Oberflächenspule eignet sich zur Erzeugung von hochfrequenten Magnetfeldern, die senkrecht zu der durch die Längs- und Querleiter definierten Fläche verlaufen bzw. zum Empfang solcher Felder.

Bei Kernspinuntersuchungen wird der zu untersuchende Patient einem starken stationären homogenen Magnetfeld ausgesetzt. Der Magnet für dieses stationäre Magnetfeld hat im allgemeinen die Form eines Hohlzylinders, in den bei einer Untersuchung der Patient hineingeschoben wird, so daß seine Längsachse parallel zur Achse des Hohlzylinders verläuft bzw. damit zusammenfällt.

Voraussetzung für die Anregung von Kernresonanzerscheinungen bzw. für das Empfangen von Kernresonanzsignalen ist, daß die (zu erzeugenden oder zu empfangenden) hochfrequenten Magnetfelder senkrecht zu dem stationären Magnetfeld verlaufen. Diese Voraussetzung läßt sich mit der bekannten Oberflächenspule in der Regel gut erfüllen, wenn diese auf die Oberfläche des Patientenkörpers aufgelegt wird und wenn - was bisher allgemein üblich war - das homogene stationäre Magnetfeld in Richtung der Zylinderachse verläuft. Das von der Oberflächenspule erzeugte hochfrequente Magnetfeld verläuft dabei nämlich senkrecht zur Oberfläche des Patienten und damit auch senkrecht zur Richtung der Hohlzylinderachse bzw. zur Richtung des stationären Magnetfeldes.

Neuerdings gibt es jedoch Magneten, die ebenfalls die Form eines Hohlzylinders haben, bei denen aber das dadurch erzeugte stationäre Magnetfeld senkrecht zur Achse des Hohlzylinders und damit senkrecht zur Längsachse des Patienten verläuft. Benutzt man die bekannte Oberflächenspule in einem solchen Magneten, dann läßt sich die Orthogonalitätsbedingung zwischen stationärem und hochfrequentem Magnetfeld nicht immer gewährleisten.

Aufgabe der vorliegenden Erfindung ist es, eine Oberflächenspule anzugeben, die in diesen Fällen einsetzbar ist. Diese Aufgabe wird erfindungsgemäß durch die im Anspruch 1 angegebenen Maßnahmen gelöst.

Bei der Erfindung teilt sich der Strom durch den Querleiter, der Bestandteil der Koppeleinrichtung ist, gleichmäßig auf die übrigen Querleiter auf. Die Ströme durch diese Querleiter rufen Hochfrequenzmagnetfelder hervor, die im Bereich zwischen den Querleitern einander entgegengerichtet sind, die jedoch außerhalb der durch die Querleiter definierte Fläche - vorzugsweise einer Ebene - die gleiche Richtung aufweisen. Das aus der Überlagerung der Magnetfelder resultierende Magnetfeld verläuft also parallel zur Oberfläche der Querleiter - im Gegensatz zu der eingangs erwähnten bekannten Oberflächenspule, bei der das Hochfrequenzmagnetfeld senkrecht zu dieser Oberfläche verläuft. Richtet man diese Spule so aus, daß bei der Benutzung die Längsleiter parallel zur Längsrichtung des Patienten verlaufen, dann verläuft das Hochfrequenzmagnetfeld senkrecht zu dem stationären Feld eines Magneten, wenn dieses auf der Zylinderachse des Magneten senkrecht steht.

Die Erfindung wird nachstehend anhand der Zeichnungen näher erläutert. Es zeigen:
- Fig. 1: eine Draufsicht auf eine erfindungsgemäße Oberflächenspule
- Fig. 2: einen seitlichen Querschnitt durch eine solche Spule
- Fig. 3: eine zweckmäßige Variante dieser Spule in perspektivischer Darstellung und
- Fig. 4: eine Quadraturspulenanordnung

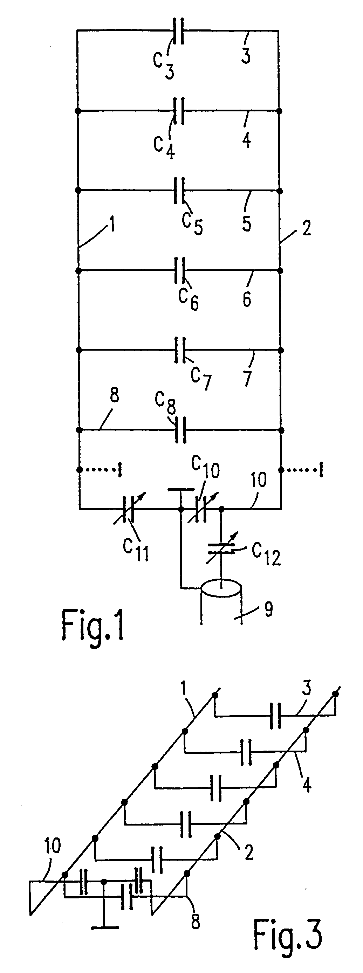

In Fig. 1 sind mit 1 und 2 zwei vorzugsweise geradlinige und parallele Leiter bezeichnet; im folgenden werden diese Leiter auch als Längsleiter bezeichnet. Diese Längsleiter werden durch eine Anzahl - im Beispiel sechs - von Leitern 3 .... 8 miteinander verbunden, die im Folgenden als Querleiter bezeichnet werden. Die Querleiter 3...8 verlaufen parallel zueinander und definieren eine Ebene; sie haben zweckmäßigerweise voneinander den gleichen Abstand. Jeder der Querleiter 3...8 enthält einen Kondensator C₃...C₈. Außerdem sind die Längsleiter 1,2 noch über einen weiteren Querleiter 10 miteinander verbunden. Dieser enthält zwei Kondensatoren C₁₀, C₁₁, deren Verbindungspunkt an Masse angeschlossen ist, und ist über einen Kondensator C₁₂ mit einem Koaxialkabel verbunden. Dieser Querzweig koppelt die Oberflächenspule über das Koaxialkabel 9 an einen nicht näher dargestellten Hochfrequenzsender oder Hochfrequenzempfänger an. Der Kondensator C₁₂ dient der Anpassung an den Wellenwiderstand des Kabels 9 und die Kondensatoren C₁₀, C₁₁ der Abstimmung auf die Betriebsfrequenz. Die Leiter 1...8, 10 können starr sein, aber auch flexibel. Im letzteren Fall ist bei Gebrauch allerdings nicht immer sichergestellt, daß die Querleiter 3...8 eine Ebene definieren und zueinander parallel verlaufen.

Die Kondensatoren C₃...C₈ sowie C₁₀...C₁₂ sind so bemessen, daß - bei Speisung durch einen Hochfrequenzsender mit der bei der Untersuchung benutzten (Larmor-) Frequenz - die Ströme durch die Querleiter 3...8 alle die gleiche Größe und Phasenlage haben, so daß die Summe dieser Ströme dem Strom durch den Querleiter 10 entspricht. In diesem Fall stellt sich auf den Längsleitern in der Mitte zwischen dem Querleiter 10 und dem benachbarten Querleiter 8 jeweils ein virtueller Massepunkt ein, d. h. die Spannung hat hier ein Minimum. Damit die Ströme durch die Querleiter 3...8 trotz dieser Spannungsverteilung konstant bleiben, muß die Kapazität des Kondensators C₈ am größten und die des Kondensators C₃ am kleinsten sein. Die Kapazität C₁₁ in Serie zu C₁₀, C₁₂ sollte in der Größenordnung der Summe der Kapazitäten C₃...C₈ liegen.

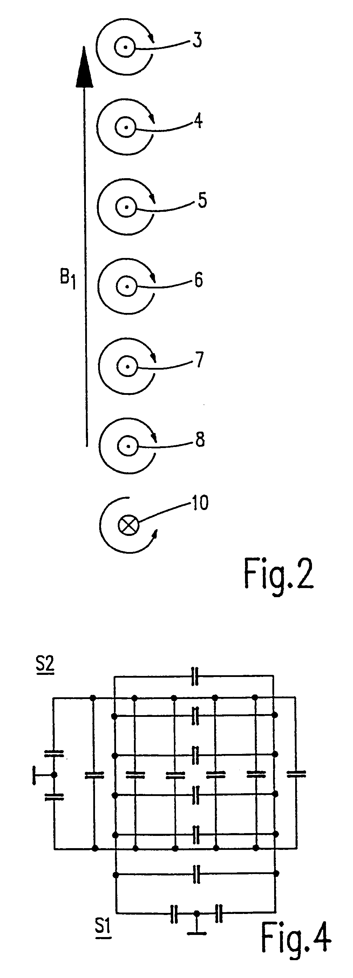

In Fig. 2 ist ein Querschnitt durch die Querleiter 3...10 dargestellt, sowie die mit den Strömen durch die Querleiter einhergehenden Magnetfelder und das resultierende Magnetfeld B₁. Die Ströme durch die Querleiter rufen in diesen ein den betreffenden Leiter umschließendes Magnetfeld mit jeweils einer Horizontal- und einer Vertikalkomponente hervor. In der Mitte zwischen zwei benachbarten Querleitern kompensieren sich die Horizontalkomponenten, während sich beiderseits der durch die Querleiter definierten Ebene durch die Überlagerung die Vertikalkomponenten addieren; es resultiert also ein zur Ebene der Querleiter paralleles und zu den Querleitern senkrecht (vertikal) verlaufendes Hochfrequenzmagnetfeld B₁.

Die benachbarten Querleiter 8 und 10 werden in entgegengesetzter Richtung von unterschiedlich großen Strömen durchflossen. Das führt dazu, daß das resultierende Magnetfeld - in diesem Bereich nicht dargestellt - nicht die gleiche Stärke und Richtung hat, wie das Magnetfeld B₁. Das gleiche gilt für die Magnetfelder, die durch die Längsleiter 1, 2 hervorgerufen werden. Um deren Einfluß zu unterdrücken, können für die beiden Längsleiter und für den Querleiter 10 abgeschirmte Leiter benutzt werden.

Fig. 3 zeigt eine andere Lösung für dieses Problem. Die Querleiter 3...8 befinden sich dabei unterhalb der durch die Längsleiter 1, 2 definierten Ebene, während der Querleiter 10 sich oberhalb dieser Ebene befindet. Die Querleiter sind dabei jeweils über nach oben bzw. nach unten gerichtete Leiterenden mit den Längsleitern verbunden. Die Magnetfelder, die mit den Strömen durch die Längsleiter und den Querleiter 10 verbunden sind, haben dabei in dem Bereich unterhalb der durch die Querleiter 3...8 definierten Ebene nur noch einen reduzierten Einfluß.

In Fig. 4 ist eine Quadraturspulenanordnung dargestellt, die zwei Oberflächenspulen gemäß Fig. 1 bzw. Fig. 3 umfaßt. Die beiden Oberflächenspulen sind derart relativ zueinander um 90° gedreht, daß die durch ihre jeweiligen Querleiter definierten Ebenen parallel zueinander verlaufen.

Obwohl die beiden Quadraturspulen S₁, S₂ Hochfrequenzmagnetfelder erzeugen, die parallel zu den durch die Querleiter definierten Ebenen verlaufen, läßt sich in der Praxis eine gewisse Kopplung zwischen den beiden Spulensystemen nicht vermeiden. Dadurch würden die bekannten Vorteile einer Quadraturspule gegenüber einer Einzelspule zunichte gemacht werden. Dies läßt sich aber vermeiden, wenn die beiden Oberflächenspulen S₁ und S₂ über einen Kondensator miteinander verbunden werden, der so bemessen ist, daß der durch ihn hervorgerufene Strom gerade den durch die magnetische Kopplung bewirkten Strom kompensiert. Im einzelnen ist dies in der deutschen Patentanmeldung DE-A-38 20 168 beschrieben.

Die in Fig. 4 dargestellte Quadraturspulenanordnung kann mit Vorteil in einem Magneten angewandt werden, dessen Hohlzylinderachse horizontal verläuft und dessen stationäres Magnetfeld senkrecht verläuft. Sie muß dann lediglich auf der Tischplatte plaziert werden, auf der der Patient gelagert wird.

## Patentansprüche

1. Oberflächenspule für Kernresonanzuntersuchungen, die zwei Längsleiter (1,2) und mehrere, wenigstens je einen Kondensator (C3 ... C8) enthaltende Querleiter (3 . . . 8, 10) zur Verbindung der Längsleiter miteinander aufweisen, sowie eine Koppeleinrichtung für den Anschluß an einen Hochfrequenzsender oder einen Hochfrequenzempfänger, dadurch gekennzeichnet, daß einer der beiden äußeren Querleiter (10) Bestandteil der Koppeleinrichtung (C10, C11, C12) ist und daß die Leiter (1 . . . 8, 10) und die Kondensatoren (C3 . . . C12) so bemessen sind, daß der Strom durch den in der Koppeleinrichtung enthaltenen Querleiter (10) sich auf die übrigen Querleiter (3 . . . 8) derart aufteilt, daß die Stromverteilung in den Querleitern nach Amplitude und Phase gleich ist.

2. Oberflächenspule nach Anspruch 1,
gekennzeichnet durch eine solche Formgebung, daß die beiden Längsleiter (1,2) und der in der Koppeleinrichtung enthaltene Querleiter (10) sich außerhalb und auf der gleichen Seite der durch die übrigen Querleiter (3..8) definierten Fläche befinden.

3. Oberflächenspule nach Anspruch 1 oder 2,
dadurch gekennzeichnet, daß die Längsleiter und der in der Koppeleinrichtung enthaltene Querleiter durch geschirmte Kabel gebildet werden.

4. Verwendung zweier um 90° um ihre Flächennormale gegeneinander verdrehte Oberflächenspulen nach Anspruch 1 zur Bildung einer Quadratur-Oberflächenspule.

## Claims

1. A surface coil for magnetic resonance examinations which comprises two longitudinal conductors (1, 2) and several transverse conductors (3 ... 8, 10) which comprise at least one respective capacitor (C3 ... C8) and which serve to interconnect the longitudinal conductors, which coil also comprises a coupling device for the connection to an RF transmitter or an RF receiver, characterized in that one of the two outer transverse conductors (10) forms part of the coupling device (C₁₀, C₁₁, C₁₂), and that the conductors (1 ... 8, 10) and the capacitors (C₃ ... C₁₁) are proportioned so that the current through the transverse conductor (10) forming part of the coupling device is distributed between the other transverse conductors (3 ... 8) in such manner, that the current distribution in the transverse conductors is the same in respect of amplitude and phase.

2. A surface coil as claimed in Claim 1, characterized in that it is constructed so that the two longitudinal conductors (1, 2) and the transverse conductor (10) forming part of the coupling device are situated outside and to the same side of the plane defined by the other transverse conductors (3 ... 8).

3. A surface coil claimed in Claim 1 or 2, characterized in that the longitudinal conductors and the transverse conductor forming part of the coupling device are formed by shielded cables.

4. The use of two surface coils as claimed in Claim 1 which have been rotated 90° relative to one another about the normal to their surface in order to form a quadrature surface coil.

## Revendications

1. Bobine de surface pour examens par RMN, comprenant deux conducteurs longitudinaux (1, 2) et plusieurs conducteurs transversaux (3...8, 10) comportant chacun au moins un condensateur (C3...C8) et destinés à relier les conducteurs longitudinaux l'un à l'autre, ainsi qu'un dispositif de couplage pour la connexion à un émetteur à haute fréquence ou bien à un récepteur à haute fréquence, caractérisée en ce que l'un des deux conducteurs transversaux (10) extérieurs fait partie du dispositif de couplage (C10, C11, C12) et en ce que les conducteurs (1...8, 10) et les condensateurs (C3..C12) sont dimensionnés de manière que le courant passant dans le conducteur transversal (10) contenu dans le dispositif de couplage se répartit sur les autres conducteurs transversaux (3...8), de manière que la distribution du courant dans les conducteurs transversaux soit identique en amplitude et en phase.

2. Bobine de surface selon la revendication 1, caractérisée par une configuration faisant que les deux conducteurs longitudinaux (1, 2) et le conducteur transversal (10) contenu dans le dispositif de couplage se trouvent à l'extérieur et du même coté de la surface définie par les autres conducteurs transversaux (3...8).

3. Bobine de surface selon la revendication 1 ou 2, caractérisée en ce que les conducteurs longitudinaux et le conducteur transversal contenu dans le dispositif de couplage sont constitués par des câbles blindés.

4. Utilisation de deux bobines de surface selon la revendication 1, tournées de 90° l'une par rapport à l'autre autour de la normale à leurs surfaces pour constituer une bobine de surface à quadrature.
